# FASCICULE DE BREVET EUROPEEN

(11) **EP 0 524 114 B1**
(45) Date de publication et mention de la délivrance du brevet: **15.03.1995**
(21) Numéro de dépôt: 92420227.8
(22) Date de dépôt: 02.07.1992
(51) Int. Cl.: C30B 25/02, C30B 25/14

(54) **Procédé de fabrication d'un cristal à gradient de maille**
Verfahren zur Herstellung eines Kristalles mit einem Gittergradient
Process for making a crystal with a lattice gradient

(30) Priorité: 05.07.1991 FR 9109109
(43) Date de publication de la demande: 20.01.1993
(73) Titulaire: INSTITUT MAX VON LAUE - PAUL LANGEVIN (Etablissement publique), F-38042 Grenoble CEDEX (FR); INSTITUT NATIONAL POLYTECHNIQUE DE GRENOBLE, F-38031 Grenoble (FR)
(72) Inventeur: Escoffier, Alain, F-38100 Grenoble (FR); Madar, Roland, F-38320 Eybens (FR); Magerl, Andreas, F-38330 Saint Ismier (FR); Mastromatteo, Eric, F-38402 Saint Martin D'Hères (FR)
(74) Mandataire: de Beaumont, Michel

(56) Documents cités:
- EP-A- 0 006 118
- DE-A- 1 816 542
- EXTENDED ABSTRACTS,SPRING MEETING,LOS ANGELES, vol. 89/91, Mai 1990, PRINCETON,NJ,US pages 1107 - 1109 K.H.JUNG ET AL 'Growth of GexSi1-x layers by rapid thermal processing chemical vapour deposition'
- PHILIPS TECHNICAL REVIEW vol. 43, no. 5-6, Mai 1987, EINDHOVEN , NLM pages 133 - 142 M.R.LEYS ETAL 'metal-organic vapour phase epitaxy with a novel reactor and characterisationof multilayer structures'
- APPLIED PHYSICS LETTERS vol. 53, no. 25, Décembre 1988, NEW YORK,USA pages 2555 - 2557 B.S MEYERSON ET AL 'cooperative growth phenonema in silicon / germanium low temperature epitaxy'
- APPLIED PHYSICS LETTERS vol. 56, no. 12, Mars 1990, NEW YORK,US pages 1107 - 1109 H.HIRAYAMA ETAL 'selective heteroepitaxial growth of si1-xgexusing gas source molecular beam epitaxy'

## Description

La présente invention concerne la cristallogénèse, et plus particulièrement la fabrication de cristaux à plusieurs éléments dans lesquels la proportion de l'un au moins des éléments est continûment variable, d'où il résulte que ces cristaux présentent un gradient de maille cristalline. De tels cristaux seront simplement appelés ci-après cristaux à gradient.

Les cristaux à gradient peuvent par exemple être utilisés comme monochromateurs de rayonnements à faible longueur d'onde tels que des neutrons ou des rayons X.

L'idée d'utiliser des cristaux à gradient comme monochromateurs de rayonnements apparaît par exemple dans le brevet allemand 18 16 542 déposé le 23 décembre 1968 au nom de l'Institut Max von Laue-Paul Langevin, Grenoble. Dans ce brevet, on mentionne en particulier l'intérêt de cristaux à gradient du type SiₓGe₁₋ₓ (x désigne une valeur comprise entre 0 et 1).

Ainsi, depuis plus de vingt ans, on a vu l'intérêt qu'il y aurait à fabriquer des cristaux à gradient. Toutefois, on n'est toujours pas arrivé à fabriquer industriellement de tels cristaux suffisamment monocristallins, suffisamment grands, et présentant une plage de variation de concentration de leurs éléments propre à fournir un gradient de maille satisfaisant. En effet, on cherche à obtenir des cristaux ayant des dimensions supérieures à quelques millimètres, par exemple une longueur dans la direction du gradient de l'ordre de 10 mm.

Les procédés de croissance de cristal peuvent se classer en deux grandes catégories, les procédés partant d'une phase liquide et les procédés partant d'une phase gazeuse. Ces deux familles de procédés de croissance cristalline sont connues depuis longtemps. Généralement, les procédés partant d'une phase liquide sont utilisés pour obtenir des cristaux de grande dimension alors que les procédés en phase gazeuse, tels que les épitaxies en phase gazeuse, sont réservés à la fabrication de cristaux en couche mince, par exemple dans le domaine de la microélectronique. L'article de Extended Abstracts, Spring Meeting, Los Angeles, Vol. 89/91, mai 1989, pages 216-217, décrit un tel procédé de dépôt de SiₓGe₁₋ₓ en couches minces à des températures de l'ordre de 1000°C pendant des durées de l'ordre de la minute.

A la connaissance de la demanderesse, toutes les tentatives de réalisation de cristaux à gradient entreprises depuis une vingtaine d'années, se sont concentrées sur la famille des procédés à phase liquide, et plus particulièrement sur des procédés de tirage dans lesquels on fait continûment varier au cours du tirage la concentration de la phase liquide. Ce sont ces procédés qui n'ont toujours pas donné de résultats satisfaisants. En particulier, dans le cas de la fabrication de cristaux à gradient du type SiₓGe₁₋ₓ, ces procédés n'ont permis de fournir des monocristaux que si la variation de concentration relative du germanium et du silicium n'était pas supérieure à quelques pour cent.

Ainsi, un objet de la présente invention est de prévoir un procédé général d'obtention de monocristaux à gradient qui permette une fabrication relativement rapide tout en fournissant une large plage de variation de concentration et une épaisseur notable.

Pour atteindre ces objets, la présente invention prévoit d'utiliser des techniques de dépôt chimique en phase vapeur, connues notamment dans le domaine de la fabrication des composants semiconducteurs, en les adaptant au problème posé. L'utilisation de ce type de technique n'avait jamais été proposée précédemment en raison, semble-t-il, du double obstacle ci-après.

Le premier obstacle est que les techniques de dépôt chimique en phase vapeur élaborées pour la fabrication de composants semiconducteurs sont destinées à la fabrication de couches minces ayant des épaisseurs de l'ordre du micromètre. Pour atteindre de telles épaisseurs, des procédés de dépôt relativement lents sont acceptables. Ainsi, couramment, les procédés de dépôt développés dans le domaine des semiconducteurs fournissent des vitesses de croissance faibles. Par exemple, un procédé usuel de dépôt de silicium-germanium implique de partir d'un mélange de silane (SiH₄) et de germane (GeH₄) en présence d'hydrogène à basse pression (0,1 Pascal) et à une température de l'ordre de 500 à 600°C. On obtient alors une vitesse de croissance de l'ordre de 1 à 5 nm par minute, ce qui donne, pour la valeur supérieure, une vitesse de croissance de 7 micromètres par jour. Il faudrait alors plusieurs années pour obtenir une croissance de l'ordre de la dizaine de millimètres.

Par ailleurs, il est connu que l'on peut augmenter les vitesses de dépôt en augmentant la température du substrat sur lequel se produit le dépôt. Toutefois, on se heurte alors à un second obstacle qui est que, à l'intérieur d'un cristal, il se produit des phénomènes de diffusion à l'état solide qui sont, par exemple, à la base des procédés d'obtention de régions différemment dopées dans un composant semiconducteur. Il est en outre connu que cette vitesse de diffusion croît avec la temperature pour devenir élevée quand on s'approche de la température de fusion du cristal. Par exemple, il est connu que si l'on forme par épitaxie une couche de germanium sur une couche de silicium, après un recuit à 1000°C pendant vingt-quatre heures, on obtient une couche intermédiaire de 200 nm de Si₁₋ₓGeₓ.

C'est sans doute en raison de ce deuxième obstacle que l'on n'a jamais essayé de fabriquer des cristaux à gradient par dépôt chimique en phase vapeur. En effet, sachant que, quand la température d'un cristal comprenant plusieurs types d'atomes augmente, la composition du cristal tend à s'homogénéiser, on pensait qu'il ne serait pas possible d'obtenir des cristaux à gradient par des procédés d'épitaxie en phase gazeuse à haute température.

La demanderesse s'est aperçue que ce second obstacle était en fait un préjugé et que, dans le cas d'un cristal à gradient d'indice formé par dépôt chimique en phase vapeur dans les conditions qui seront exposées ci-après, ce phénomène d'interdiffusion et d'homogénéisation ne se produit pas ou se produit seulement de façon négligeable.

Ainsi, la présente invention propose un procédé de fabrication d'un cristal d'une épaisseur supérieure à 1 mm et présentant un gradient de maille cristalline comprenant au moins deux éléments dans lequel la proportion de l'un au moins de ces éléments varie dans une direction choisie, consistant à procéder à une croissance cristalline par voie chimique en phase vapeur en faisant varier de façon continue au cours du temps la proportion de chacun des composants dans le gaz à partir duquel est formé le dépôt à une température située de 10 à 30 % au-dessous de la température de fusion du cristal.

Selon une application de la présente invention, le cristal considéré est SiₓGe₁₋ₓ. Les gaz de dépôt sont un mélange de silane et de germane en présence d'hydrogène. Le dépôt est réalisé avec une pression de gaz de l'ordre de 100 pascals et une température de l'ordre de 950 à 1200°C.

Selon un mode de réalisation de la présente invention, la proportion des gaz de dépôt est modifiée pour que la variation de proportion d'un élément soit de quelques pour cent par millimètre dans le cristal obtenu.

### Exemple

Dans une expérience pratique, on a procédé dans un réacteur à parois froides où le substrat de silicium était porté à 1000°C à une pression totale de 100 pascals (1 Torr). Dans ce réacteur on a fait circuler des gaz a un débit de 1 litre/minute en partant d'un mélange de SiH₄ (50 à 100 cm³/mn), HCl (2 à 10 cm³/mn) et le complément en hydrogène. Progressivement, une quantité croissante de GeH₄ a été introduite tandis que la quantité de SiH₄ était maintenue constante, pour obtenir une formation SiₓGe₁₋ₓ avec une valeur décroissante de x. Au bout de 24 heures, on a obtenu un cristal de SiₓGe₁₋ₓ d'une épaisseur de 1mm. La vitesse de croissance était de 0,6 à 0,8 micromètre par minute, c'est-à-dire plus de 1000 fois plus élevée que les vitesses précédemment mentionnées. En partant d'un substrat de silicium pur, on est arrivé en faisant varier la concentration de germane dans le mélange de la façon indiquée à une composition en surface pour une épaisseur d'un millimètre de Si_{0,97}Ge_{0,03}.

Les résultats obtenus par la demanderesse montrent que pour des couches plus épaisses (10 mm), on pourrait atteindre une composition de surface voisine de Si_{0,70}Ge_{0,30}.

Inversement, on pourrait partir d'un substrat de germanium pour arriver à une couche externe ayant une composition superficielle du type Ge_{0,70}Si_{0,30}.

Selon l'application envisagée, on conservera le silicium ou le germanium de départ comme substrat pour le cristal à gradient obtenu ou bien on enlèvera par abrasion ce substrat pour obtenir uniquement la partie du cristal à gradient d'indice.

Au lieu de silane et de germane, on pourrait utiliser des dérivés halogénés tels que SiH₄₋ₙClₙ ou GeH₄₋ₙClₙ.

Bien que l'exemple donné concerne uniquement le SiₓGe₁₋ₓ, la présente invention s'applique plus généralement à la formation d'autres cristaux à gradient, par exemple Ga₁₋ₓAlₓAs ou In₁₋ₓGaₓP.

On notera que le procédé selon la présente invention permet d'éviter deux problèmes qui rendent la croissance en phase liquide difficile, voire impossible, dans le cas SiₓGe₁₋ₓ.

Premièrement, un atome de germanium dans une matrice de silicium représente un défaut qui' a tendance à créer des perturbations à plus longue distance. Cet effet empêche une croissance cristalline lorsque le réseau de silicium n'est plus assez rigide, ce qui devient le cas pour une température supérieure à 1000°C environ.

Deuxièmement, les concentrations des constituants d'un alliage sont différentes dans la phase liquide et la phase solide. Elles doivent être équilibrées par les processus dynamiques près du front de solidification. Dans le cas de SiₓGe₁₋ₓ, ces différences sont très importantes. Elles demandent un fort échange de matière près du front de solidification. En conséquence, le front de solidification devient instable et une croissance monocristalline ne peut être maintenue.

## Revendications

1. Procédé de fabrication d'un cristal d'une épaisseur supérieure à 1 mm et présentant un gradient de maille cristalline comprenant au moins deux éléments dans lequel la proportion de l'un au moins de ces éléments varie dans une direction choisie, caractérisé en ce qu'il consiste à procéder à une croissance cristalline par voie chimique en phase vapeur en faisant varier de façon continue au cours du temps la proportion de chacun des composants dans le gaz à partir duquel est formé le dépôt, à une température située de 10 à 30 % en dessous de la température de fusion du cristal.

2. Procédé selon la revendication 1, caractérisé en ce que ledit cristal est SiₓGe₁₋ₓ.

3. Procédé selon la revendication 2, caractérisé en ce que les gaz de dépôt sont un mélange de silane et de germane en présence d'hydrogène.

4. Procédé selon la revendication 3, caractérisé en ce qu'il est mis en oeuvre à une pression de gaz de l'ordre de 100 pascals et à une température de l'ordre de 950 à 1200°C.

5. Procédé selon l'une quelconque des revendications 1 à 4, caractérisé en ce que la proportion des gaz de dépôt est modifiée pour que la variation de proportion d'un élément soit de quelques pour cent par millimètre dans le cristal obtenu.

## Claims

1. A method for manufacturing a crystal of a thickness larger than 1 mm and exhibiting a gradient of the crystalline lattice, comprising at least two elements wherein the proportion of at least one element varies in a given direction, characterized in that a CVD crystal growth is used, while continuously varying as a function of time the proportion of each of the components of the gas from which the growth is formed, at a temperature comprised between approximately 10 and approximately 30 percent under the melting temperature of the crystal.

2. A method according to claim 1, characterized in that said crystal is SiₓGe₁₋ₓ.

3. A method according to claim 2, characterized in that the deposition gases are a mixture of silane and germane, with hydrogen.

4. A method according to claim 3, characterized in that the total gas pressure is approximately 100 pascals at a temperature in the range of 950-1200°C.

5. A method according to any of claims 1 to 4, characterized in that the composition of the gas mixture is varied so that the variation of the proportion of one element in the obtained crystal is equal to some percentage units per millimeter.

## Patentansprüche

1. Verfahren zum Herstellen eines Kristalles mit einer Dicke größer als 1 mm, der einen Gradienten des Kristallgitters zeigt und zumindest zwei Stoffe enthält, wobei der Anteil zumindest einer dieser Stoffe in einer gewählten Richtung variiert, dadurch gekennzeichnet, daß das Verfahren darin besteht, ein Kristallwachsen auf chemischem Wege in der Dampfphase bei einer Temperatur, die 10 % bis 30 % unter der Schmelztemperatur des Kristalles gelegen ist, zu verwenden, wobei kontinuierlich im Laufe der Zeit der Anteil jeder Komponente in dem Gas, aus dem die Ablagerung gebildet wird, geändert wird.

2. Verfahren nach Anspruch 1, dadurch gekennzeichnet, daß der Kristall SiₓGe₁₋ₓ ist.

3. Verfahren nach Anspruch 2, dadurch gekennzeichnet, daß die Abscheidungsgase eine Mischung aus Silan und German in Gegenwart von Wasserstoff sind.

4. Verfahren nach Anspruch 3, dadurch gekennzeichnet, daß es bei einem Gasdruck in der Größenordnung von 100 Pascal und bei einer Temperatur in der Größenordnung von 950 bis 1200°C ausgeführt wird.

5. Verfahren nach einem der Ansprüche 1 bis 4, dadurch gekennzeichnet, daß der Anteil der Abscheidungsgase modifiziert wird, damit die Änderung des Anteiles eines Elementes einige Prozent pro Millimeter in dem erhaltenen Kristall ist.
